# EUROPÄISCHE PATENTSCHRIFT

(11) **EP 3 791 243 B1**
(45) Veröffentlichungstag und Bekanntmachung des Hinweises auf die Patenterteilung: **02.10.2024**
(21) Anmeldenummer: 18727673.8
(22) Anmeldetag: 09.05.2018
(51) Int. Cl.: G05G 1/08, F24C 7/00, G01D 5/26, H03K 17/968, G05G 25/04

(54) **BEDIENVORRICHTUNG MIT DREHBAREM BEDIENELEMENT**
OPERATING DEVICE WITH A ROTATABLE OPERATING ELEMENT
DISPOSITIF DE COMMANDE À PANNEAU DE COMMANDE ROTATIF

(43) Veröffentlichungstag der Anmeldung: 17.03.2021
(73) Patentinhaber: Diehl AKO Stiftung & Co. KG, 88239 Wangen (DE)
(72) Erfinder: HAHS, Charles, A., Jr., 50-344 Wroclaw (PL); KRAMEK, Rafal, 53-150 Wroclaw (PL)
(74) Vertreter: Diehl Patentabteilung
(86) Internationale Anmeldenummer: PCT/EP2018/000247
(87) Internationale Veröffentlichungsnummer: WO 2019/214795

(56) Entgegenhaltungen:
- EP-A1- 2 821 709
- WO-A1-2012/080155
- DE-A1- 102012 217 347
- DE-U1- 202016 007 628
- US-A1- 2016 259 301

## Beschreibung

Die vorliegende Erfindung betrifft eine Bedienvorrichtung, insbesondere eine Bedienvorrichtung für ein elektronisches Haushaltsgerät, mit einem drehbaren Bedienelement.

In elektronischen Haushaltsgeräten werden häufig Bedienvorrichtungen eingesetzt, bei denen ein Benutzer durch Drehen eines Bedienelements einen gewünschten Wert eines Parameters wie beispielsweise einer Kochstufe, einer Kochzeit und dergleichen einstellen kann. Zum Erfassen einer Drehbetätigung des Bedienelements sind dem Fachmann auch optische Technologien bekannt.

Die WO 2018/014926 A1 offenbart eine Drehbetätigungsvorrichtung mit einem um eine Drehachse drehbar gelagerten Betätigungsknopf und einer Erfassungseinrichtung zum Erfassen einer Drehbetätigung des Betätigungsknopfes, wobei der Betätigungsknopf einen Reflexionsabschnitt aufweist, der Reflexionsflächen mit entlang einer Umfangsrichtung des Betätigungsknopfes unterschiedlichen Reflexionspositionen aufweist, und die Erfassungseinrichtung wenigstens einen ortsfesten optischen Abstandssensor zum Erfassen eines Abstandes zwischen dem Abstandssensor und einer dem Abstandssensor aktuell zugewandten Reflexionsfläche des Reflexionsabschnitts des Betätigungsknopfes aufweist. Der Betätigungsknopf ist in einer Durchbrechung einer Bedienblende positioniert, sodass je nach Einsatzgebiet der Drehbetätigungsvorrichtung spezielle Dichtungsmaßnahmen zwischen der Bedienblende und dem drehbaren Betätigungsknopf erforderlich sind.

Die DE 10 2004 013 947 B3 offenbart eine Bedienvorrichtung für ein Gaskeramikkochfeld in der Form eines Drehknebels, bei der an der Unterseite des Drehknebels ein Messstreifen vorgesehen ist, der auf einer Kreisbahn angeordnet ist und sich entlang der Kreisbahn kontinuierlich oder stufenweise verändernde physikalische Eigenschaften aufweist, und das Glaskeramikkochfeld wenigstens einen optischen oder kapazitiven Sensor aufweist, der entsprechend der Kreisbahn des Messstreifens angeordnet ist und ein der physikalischen Eigenschaft des dem Sensor gegenüberliegenden Abschnitts des Messstreifens entsprechendes Ausgangssignal erzeugt, und dem wenigstens einen Sensor eine Auswerteeinheit zugeordnet ist, die aus dem Ausgangssignal des Sensors ein der Drehposition des Drehknebels entsprechendes Stellsignal für das Glaskeramickochfeld erzeugt. Die Verwendung eines optischen Sensors ist nur bei einem transparenten Glaskeramikkochfeld möglich.

Ferner offenbart EP 2 821 709 A1 eine Bedienvorrichtung für ein Haushaltsgerät, welche ein Bedienelement auf einer Bedienelementaufnahme (z.B. Teilfläche einer Kochfeldplatte) des mit der Bedienvorrichtung steuerbaren Haushaltsgeräts (z.B. Kochfeld) aufweist, wobei der Schaltungsträger mit Lichtquellen und Detektoren zur Dreherkennung des Bedienelements innerhalb des Haushaltsgeräts (z.B. unter der Kochfeldplatte) angeordnet ist.

Außerdem offenbart DE 10 2012 217 347 A1 eine Eingabevorrichtung für ein Elektrogerät, auf welcher der Oberbegriff des unabhängigen Anspruchs 1 basiert.

Der Erfindung liegt die Aufgabe zugrunde, eine Bedienvorrichtung mit einem drehbaren Bedienelement zu schaffen, welche einerseits in Kombination mit beliebigen Bedienblenden verwendbar ist und andererseits bei einfachem Aufbau gute Dichtheitseigenschaften gegenüber der Bedienblende besitzt.

Diese Aufgabe wird gelöst durch eine Bedienvorrichtung mit den Merkmalen des Anspruchs 1. Besonders vorteilhafte Ausgestaltungen und Weiterbildungen der Erfindung sind Gegenstand der abhängigen Ansprüche.

Die Bedienvorrichtung der Erfindung weist auf: eine Bedienblende mit einer Aussparung in Form einer Durchbrechung; eine Leiterplatte, die auf einer einem Benutzer abgewandten Innenseite der Bedienblende angeordnet ist; ein Bedienelement, das zumindest teilweise innerhalb der Aussparung der Bedienblende angeordnet ist und um eine senkrecht zur Ebene der Bedienblende verlaufende Drehachse drehbar ist; und eine Dreherfassungseinrichtung zum Erfassen einer Drehbewegung und/oder einer Drehstellung des Bedienelements, die einen an dem Bedienelement vorgesehenen Encoder und einen auf der Leiterplatte angeordneten optischen Sensor aufweist. Außerdem weist die Bedienvorrichtung ein geschlossenes fluiddichtes Halteelement auf, das in die Aussparung der Bedienblende eingesetzt ist und mittels einer Dichtungseinrichtung gegenüber der Bedienblende fluiddicht abgedichtet ist. Dieses Halteelement hat einen Aufnahmeabschnitt zum zumindest teilweisen Aufnehmen des Bedienelements, wobei das Bedienelement in dem Aufnahmeabschnitt drehbar gelagert ist, und ist in einem zwischen dem Encoder des Bedienelements und dem optischen Sensor der Leiterplatte vorgesehenen Abschnitt in Bezug auf die vom optischen Sensor verwendete Strahlung zumindest teilweise durchlässig ausgestaltet, und weist im Bereich des Aufnahmeabschnitts eine Klemmvorrichtung zum Verrasten des Bedienelements in einer Richtung parallel zur Drehachse des Bedienelements im Aufnahmeabschnitt auf.

Durch Einsetzen eines geschlossenen Halteelements in die Aussparung der Bedienblende zum Halten des drehbaren Bedienelements müssen keine besonderen Anforderungen an die Bedienblende gestellt werden (insbesondere muss sie nicht strahlungsdurchlässig sein), sodass sie grundsätzlich aus einem beliebigen Material gefertigt sein kann, und entfällt eine Abdichtung zwischen der Bedienblende und einem drehenden Bauteil, sodass die fluiddichte Abdichtung einfacher und zugleich effektiver realisiert werden kann.

Die Bedienvorrichtung der Erfindung ist insbesondere für elektronische Haushaltsgeräte wie Kochfelder, Herde, Spülmaschinen, Wäschebehandlungsgeräte, Kühl- und/oder Gefriergeräte und dergleichen, in vorteilhafter Weise einsetzbar, ohne auf diese Anwendung beschränkt zu sein.

Die Aussparung in der Bedienblende ist vorzugsweise im Wesentlichen kreisförmig ausgestaltet, kann aber auch zum Beispiel rechteckig oder quadratisch geformt sein. Dementsprechend hat das Halteelement vorzugsweise einen im Wesentlichen kreisförmigen Außenumfang.

Die Dichtungseinrichtung zwischen der Bedienblende und dem Halteelement weist eine Labyrinthdichtung auf, die bevorzugt durch ineinandergreifende Profile an der Aussparung der Bedienblende und dem Außenumfang des Halteelements gebildet ist, und optional eine Verklebung zwischen den beiden Komponenten. Die Dichtungseinrichtung sorgt für eine fluiddichte, d.h. zumindest spritzwasserdichte, bevorzugt wasserdichte Abdichtung des Halteelements gegenüber der Bedienblende, sodass die Leiterplatte und die darauf montierten elektronischen Bauteile hinter einer geschlossenen Oberfläche aus Bedienblende und Halteelement geschützt sind.

Der optische Sensor auf der Leiterplatte weist vorzugsweise wenigstens einen Sender und wenigstens einen Empfänger auf. Der optische Sensor ist vorzugsweise als IR-Sensor ausgestaltet. Der optische Sensor erfasst eine Drehbewegung oder Drehstellung des Encoders und damit des Bedienelements durch Auswerten der am Encoder reflektierten Strahlung.

Die Strahlungsdurchlässigkeit des Abschnitts des Halteelements zwischen dem Encoder des Bedienelements und dem optischen Sensor der Leiterplatte ist vorzugsweise durch das Material des Halteelements oder ein aus einem anderen Material gefertigtes und in das Halteelement integriertes Fenster realisiert.

In einer vorteilhaften Ausgestaltung der Erfindung weist der Encoder des Bedienelements eine entlang der Umfangsrichtung des Bedienelements codierte Reflexionsfläche auf. Die Codierung erfolgt vorzugsweise mechanisch (z.B. durch variable Abstände zum optischen Sensor) und/oder optisch (z.B. durch variable Farben oder variable Reflexionseigenschaften) in der Umfangsrichtung des Bedienelements.

In einer vorteilhaften Ausgestaltung der Erfindung weist der Aufnahmeabschnitt des Halteelements eine Vertiefung auf, ist der Encoder des Bedienelements innerhalb dieser Vertiefung positioniert, und sind ein der Leiterplatte zugewandter Bodenabschnitt dieser Vertiefung und/oder eine Seitenwand dieser Vertiefung zumindest teilweise strahlungsdurchlässig ausgestaltet. Die Vertiefung kann zum Beispiel durch eine Nut in einem plattenförmigen Bedienelement oder durch ein Profil des Bedienelements gebildet sein.

Das Bedienelement der Bedienvorrichtung ist vorzugsweise im Wesentlichen kreisförmig oder kreisringförmig ausgebildet. Der Encoder des Bedienelements ist vorzugsweise vollständig oder abschnittweise entlang eines Kreisrings angeordnet. Dementsprechend ist die Vertiefung des Halteelements vorzugsweise im Wesentlichen kreisringförmig ausgestaltet.

In einer vorteilhaften Ausgestaltung der Erfindung ist das Bedienelement im Wesentlichen kreisringförmig ausgebildet. In diesem Fall ist ein zentraler Abschnitt des Halteelements bevorzugt zumindest teilweise lichtdurchlässig ausgestaltet und weist die Bedienvorrichtung ferner eine Anzeigevorrichtung auf, die im Bereich dieses zentralen Abschnitts des Halteelements auf der Leiterplatte angeordnet ist.

In einer vorteilhaften Ausgestaltung der Erfindung ist das Bedienelement im Wesentlichen kreisringförmig ausgebildet. In diesem Fall weist die Bedienvorrichtung bevorzugt ferner im Bereich eines zentralen Abschnitts des Halteelements wenigstens eine Berührungstaste (d.h. berührungs- und/oder annäherungsempfindlicher Tastschalter) auf. Die Berührungstaste arbeitet bevorzugt kapazitiv oder optisch.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:
- Fig. 1: eine perspektivische Schnittansicht einer Bedienvorrichtung gemäß einem ersten Ausführungsbeispiel der Erfindung;
- Fig. 2: eine vergrößerte Detailansicht von Fig. 1;
- Fig. 3: eine perspektivische Schnittansicht einer Bedienvorrichtung gemäß einem zweiten Ausführungsbeispiel der Erfindung;
- Fig. 4: eine perspektivische Schnittansicht einer Bedienvorrichtung gemäß einem dritten Ausführungsbeispiel der Erfindung; und
- Fig. 5: eine perspektivische Schnittansicht einer Bedienvorrichtung gemäß einem vierten Ausführungsbeispiel der Erfindung.

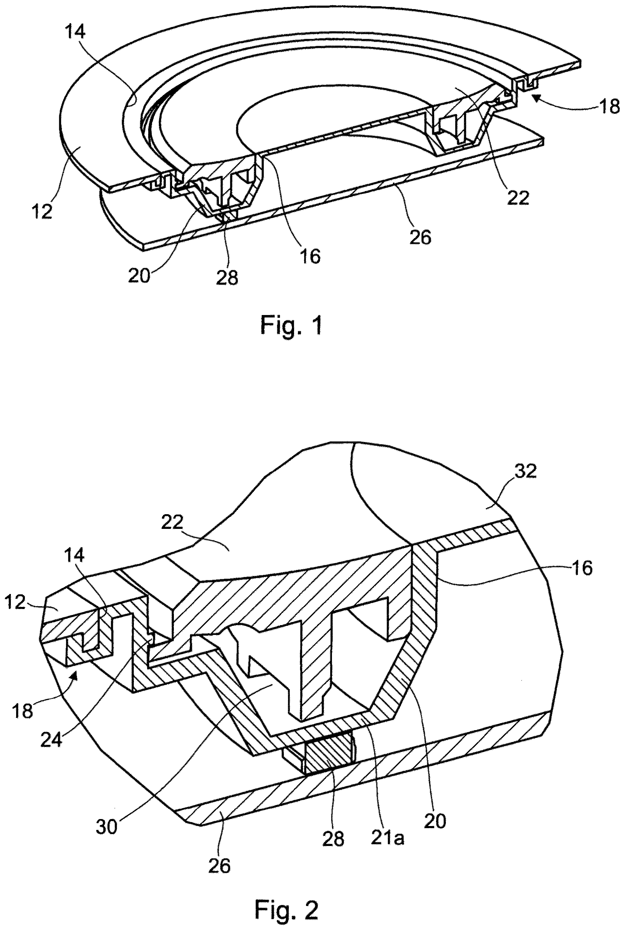

Ein erstes Ausführungsbeispiel einer erfindungsgemäßen Bedienvorrichtung wird Bezug nehmend auf Fig. 1 und 2 näher erläutert.

Die Bedienvorrichtung enthält eine Bedienblende 12 aus einem beliebigen Material, in der eine im Wesentlichen kreisförmige Aussparung 14 in Form einer Durchbrechung ausgebildet ist. Auf der dem Benutzer abgewandten Innenseite der Bedienblende 12 (unten in den Figuren) ist eine Leiterplatte 26 mit Abstand zur Bedienblende 12 angeordnet. Die Leiterplatte 26 ist im Wesentlichen parallel zur Bedienblende 12 ausgerichtet.

In die Aussparung 14 der Bedienblende 2 ist ein Halteelement 16 eingesetzt. Das Halteelement ist als ein geschlossener fluiddichter Körper ausgebildet. Der Außenumfangsrand des Halteelements 16 hat ein Profil, das mit einem Profil der Bedienblende 12 am Rand zur Aussparung 14 in Eingriff steht und auf diese Weise eine fluiddichte, d.h. zumindest spritzwasserdichte Labyrinthdichtung 18 bildet. Zusätzlich zu dieser Labyrinthdichtung 18 können auch noch weitere Dichtelemente wie beispielsweise O-Ringe vorgesehen sein. Durch diese Dichtungseinrichtung 18 ist die Leiterplatte 26 hinter der geschlossenen Oberfläche aus Bedienblende 12 und Halteelement 16 geschützt.

Die Leiterplatte 26 ist wahlweise separat von dem Halteelement 16 vorgesehen oder an diesem befestigt.

Die Bedienvorrichtung enthält ferner ein Bedienelement 22, das innerhalb der Aussparung 14 der Bedienblende 12 drehbar gelagert ist. Zu diesem Zweck weist das Halteelement 16 einen Aufnahmeabschnitt 20 in Form einer im Wesentlichen kreisringförmigen Vertiefung auf, in dem das Bedienelement 22 zumindest teilweise aufgenommen ist. Im Bereich des Aufnahmeabschnitts 20 weist das Halteelement 16 zudem eine Klemmvorrichtung 24 zum Beispiel in Form einer Rastnase auf. Auf diese Weise ist das Bedienelement 22 um eine Drehachse, die im Wesentlichen senkrecht zur Ebene der Bedienblende 12 verläuft drehbar gelagert und zugleich in einer Richtung parallel zur Drehachse am/im Halteelement 16 gehalten.

In dem gezeigten Ausführungsbeispiel ist das Bedienelement 22 als ein im Wesentlichen kreisringförmiger Scheibenkörper ausgestaltet. In anderen Ausführungsformen kann das Bedienelement 22 auch im Wesentlichen kreisförmig und/oder als Drehknebel ausgestaltet sein. Das Material des Bedienelements 22 ist grundsätzlich beliebig, in diesem Ausführungsbeispiel ist es aus einem Kunststoffmaterial gefertigt.

Wie in Fig. 1 und 2 veranschaulicht, weist das Bedienelement 22 im Bereich des Aufnahmeabschnitts 20 - in anderen Ausführungsformen alternativ auch in anderen Bereichen des Halteelements 16 - einen Encoder 30 auf. Der Encoder 30 verläuft vollumfänglich oder abschnittweise entlang der Umfangsrichtung und hat auf seiner der Leiterplatte 26 zugewandten unteren Seite eine Reflexionsfläche. Diese Reflexionsfläche ist entlang der Umfangsrichtung durch variable Abstände zur Leiterplatte 26 codiert. In anderen Ausführungsformen kann die Reflexionsfläche des Encoders 30 durch variable Farben oder variable Reflexionseigenschaften alternativ oder zusätzlich auch optisch codiert sein.

Auf der Leiterplatte 26 ist an wenigstens einer Position entsprechend der Vertiefung 20 bzw. des Encoders 30 ein optischer Sensor 28 vorgesehen. Der optische Sensor 28, bevorzugt ein IR-Sensor, enthält wenigstens einen Sender und wenigstens einen Empfänger. Wahlweise können auch mehrere optische Sensoren 28 entlang des Bereichs der Vertiefung 20 positioniert sein.

Je nach Drehstellung des Bedienelements 22 ist gegenüber dem optischen Sensor 28 ein anderer Abschnitt des Bedienelements 22 bzw. seines Encoders 30 positioniert. Dementsprechend wird die vom Sender des Sensors 28 ausgesendete Strahlung unterschiedlich reflektiert, sodass aus der vom Empfänger des Sensors 28 detektierten reflektierten Strahlung auf die Drehstellung und/oder eine Drehbewegung des Bedienelements 22 geschlossen werden kann.

Das Halteelement 16 ist im Bereich des Bodenabschnitts 21a der Vertiefung 20 zumindest im Bereich des Sensors 28 oder der Sensoren 28 für die von den Sensoren 28 verwendete Strahlung zumindest teilweise durchlässig ausgestaltet. Das Halteelement 16 ist bevorzugt aus einem (teil)transparenten Kunststoffmaterial gefertigt.

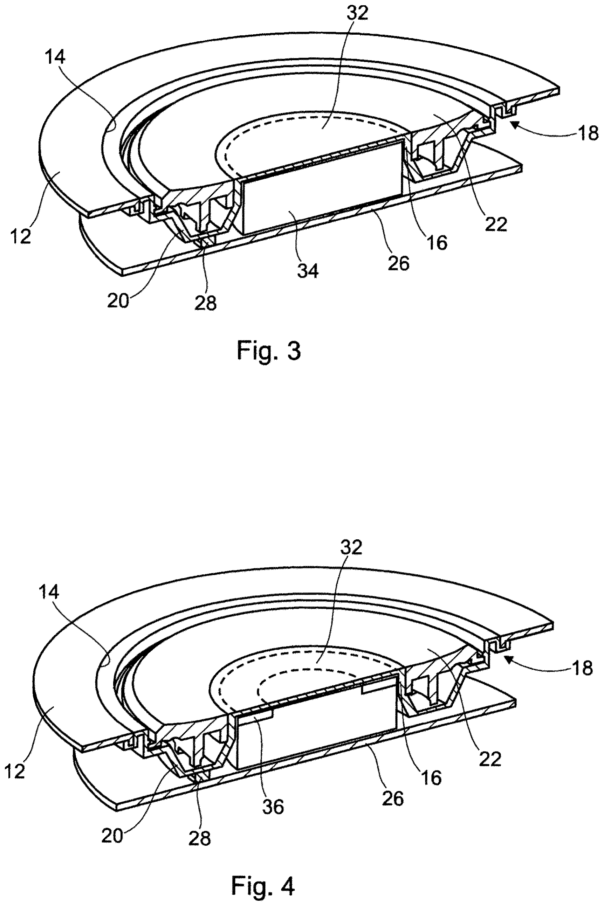

Fig. 3 zeigt eine Bedienvorrichtung gemäß einem zweiten Ausführungsbeispiel der Erfindung. Dabei sind gleiche Komponenten mit den gleichen Bezugsziffern wie im ersten Ausführungsbeispiel gekennzeichnet.

Im Vergleich zum obigen ersten Ausführungsbeispiel weist die Bedienvorrichtung des zweiten Ausführungsbeispiels zudem eine Anzeigevorrichtung 34 in Form eines Displays auf. Diese Anzeigevorrichtung 34 ist auf der Leiterplatte 26 im Bereich des zentralen Abschnitts 32 des Halteelements 16 angeordnet. Der zentrale Abschnitt 32 des Halteelements 16 ist daher zumindest teilweise lichtdurchlässig ausgestaltet. Anstelle eines Displays kann die Anzeigevorrichtung 34 auch ein einfaches Leuchtmittel zum Hinterleuchten des optional maskierten, zentralen Abschnitts 32 des Halteelements 16 aufweisen.

Im Übrigen entspricht die Bedienvorrichtung von Fig. 3 jener des ersten Ausführungsbeispiels.

Fig. 4 zeigt eine Bedienvorrichtung gemäß einem dritten Ausführungsbeispiel der Erfindung. Dabei sind gleiche Komponenten mit den gleichen Bezugsziffern wie im ersten und zweiten Ausführungsbeispiel gekennzeichnet.

Im Vergleich zum obigen ersten Ausführungsbeispiel weist die Bedienvorrichtung des zweiten Ausführungsbeispiels zudem wenigstens eine Berührungstaste (berührungs- und/oder annäherungsempfindlicher Tastschalter) 36 auf. Diese Berührungstaste 36 ist im Bereich des zentralen Abschnitts 32 des Halteelements 16 vorgesehen, optional teilweise in das Halteelement 16 integriert. Im Fall einer Berührungstaste 36 mit kapazitivem Sensor ist der zentrale Abschnitt 32 des Halteelements 16 elektrisch nicht-leitend ausgestaltet, im Fall einer Berührungstaste 36 mit optischem Sensor ist der zentrale Abschnitt 32 des Halteelements 16 zumindest teilweise lichtdurchlässig ausgestaltet.

Im Übrigen entspricht die Bedienvorrichtung von Fig. 4 jener des ersten Ausführungsbeispiels.

In einer weiteren Ausführungsform der Erfindung können die beiden Ausführungsbeispiele von Fig. 3 und Fig. 4 auch miteinander kombiniert werden. D.h. im Bereich des zentralen Abschnitts 32 des Halteelements 16 sind eine Anzeigevorrichtung 34 und wenigstens eine Berührungstaste 36 vorgesehen.

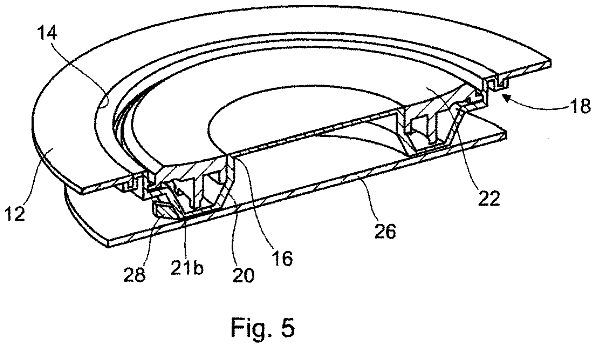

Fig. 5 zeigt eine Bedienvorrichtung gemäß einem vierten Ausführungsbeispiel der Erfindung. Dabei sind gleiche Komponenten mit den gleichen Bezugsziffern wie im ersten Ausführungsbeispiel gekennzeichnet.

Im Vergleich zum obigen ersten Ausführungsbeispiel weist ist die mechanisch oder optisch entlang der Umfangsrichtung des Bedienelements 22 codierte Reflexionsfläche des Encoders 30 nicht auf seiner der Leiterplatte 26 zugewandten unteren Seite, sondern an seiner radial äußeren Seite vorgesehen. Dementsprechend ist auch der wenigstens eine optische Sensor 28 radial außerhalb der Vertiefung des Halteelements 16 auf der Leiterplatte 26 positioniert. Außerdem ist das Halteelement 16 im Bereich der äußeren Seitenwand 21b zumindest im Bereich des Sensors 28 oder der Sensoren 28 für die von den Sensoren 28 verwendete Strahlung zumindest teilweise durchlässig ausgestaltet.

In weiteren Ausführungsvarianten der Erfindung können alternativ oder zusätzlich der wenigstens eine optische Sensor 28 radial innerhalb der Vertiefung auf der Leiterplatte 26 positioniert sein und dementsprechend die codierte Reflexionsfläche des Encoders 30 an seiner radial inneren Seite ausgebildet und die innere Seitenwand 21b der Vertiefung zumindest teilweise strahlungsdurchlässig ausgestaltet sein. In noch weiteren Ausführungsvarianten können optische Sensoren 28 sowohl neben einer Seitenwand 21b der Vertiefung des Halteelements 16 und unterhalb des Bodenabschnitts 21a der Vertiefung des Halteelements 16 positioniert sein.

Im Übrigen entspricht die Bedienvorrichtung von Fig. 5 jener des ersten Ausführungsbeispiels.

In einer weiteren Ausführungsform der Erfindung kann das in Fig. 5 dargestellte Ausführungsbeispiel auch mit dem Ausführungsbeispiel von Fig. 3 und/oder dem Ausführungsbeispiel von Fig. 4 kombiniert werden. D.h. im Bereich des zentralen Abschnitts 32 des Halteelements 16 sind zudem eine Anzeigevorrichtung 34 und/oder wenigstens eine Berührungstaste 36 vorgesehen.

### BEZUGSZIFFERNLISTE

- 12: Bedienblende
- 14: Aussparung
- 16: geschlossenes Halteelement
- 18: Dichtungseinrichtung, insbes. Labyrinthdichtung
- 20: Aufnahmeabschnitt
- 21a: Bodenabschnitt des Aufnahmeabschnitts
- 21b: Seitenwand des Aufnahmeabschnitts
- 22: drehbares Bedienelement
- 24: Klemmvorrichtung
- 26: Leiterplatte
- 28: optischer Sensor, insbes. IR-Sensor
- 30: Encoder, insbes. mechanisch oder optisch codierte Reflexionsfläche
- 32: zentraler Abschnitt des Halteelements
- 34: Anzeigevorrichtung
- 36: Berührungstaste

## Patentansprüche

1. Bedienvorrichtung, insbesondere für ein elektronisches Haushaltsgerät, aufweisend:
eine Bedienblende (12) mit einer Aussparung (14) in Form einer Durchbrechung;
eine Leiterplatte (26), die auf einer einem Benutzer abgewandten Innenseite der Bedienblende (12) angeordnet ist;
ein Bedienelement (22), das zumindest teilweise innerhalb der Aussparung (14) der Bedienblende (12) angeordnet ist und um eine senkrecht zur Ebene der Bedienblende (12) verlaufende Drehachse drehbar ist;
eine Dreherfassungseinrichtung zum Erfassen einer Drehbewegung und/oder einer Drehstellung des Bedienelements (22), die einen an dem Bedienelement (22) vorgesehenen Encoder (30) und einen auf der Leiterplatte (26) angeordneten optischen Sensor (28) aufweist; und
ein Halteelement (16) mit einem Aufnahmeabschnitt (20) zum zumindest teilweisen Aufnehmen des Bedienelements (22), wobei das Bedienelement (22) in dem Aufnahmeabschnitt (20) drehbar gelagert ist, und wobei das Halteelement (16) in einem zwischen dem Encoder (30) des Bedienelements (22) und dem optischen Sensor (28) der Leiterplatte (26) vorgesehenen Abschnitt (21a, 21b) in Bezug auf die vom optischen Sensor (28) verwendete Strahlung zumindest teilweise durchlässig ausgestaltet ist,
**dadurch gekennzeichnet, dass**
das Halteelement (16) ein geschlossenes fluiddichtes Halteelement ist, das in die Aussparung (14) der Bedienblende (12) eingesetzt ist und mittels einer Dichtungseinrichtung (18), die eine Labyrinthdichtung aufweist, gegenüber der Bedienblende (12) fluiddicht abgedichtet ist, sodass die Leiterplatte (26) hinter einer geschlossenen fluiddichten Oberfläche aus Bedienblende (12) und
Halteelement (16) geschützt ist; und
das Haltelement (16) im Bereich des Aufnahmeabschnitts eine Klemmvorrichtung (24) zum Verrasten des Bedienelements (22) in einer Richtung parallel zur Drehachse des Bedienelements (22) in dem Aufnahmeabschnitt (20) aufweist.

2. Bedienvorrichtung nach Anspruch 1, bei welcher der Encoder (30) des Bedienelements (22) eine entlang der Umfangsrichtung des Bedienelements codierte Reflexionsfläche aufweist.

3. Bedienvorrichtung nach einem der vorhergehenden Ansprüche, bei welcher der Aufnahmeabschnitt (20) des Halteelements (16) eine Vertiefung aufweist, der Encoder (30) des Bedienelements (22) innerhalb der Vertiefung positioniert ist, und ein der Leiterplatte (26) zugewandter Bodenabschnitt (21a) der Vertiefung und/ oder eine Seitenwand (21b) der Vertiefung zumindest teilweise strahlungsdurchlässig ausgestaltet sind.

4. Bedienvorrichtung nach einem der vorhergehenden Ansprüche, bei welcher das Bedienelement (22) im Wesentlichen kreisförmig oder kreisringförmig ausgebildet ist.

5. Bedienvorrichtung nach einem der vorhergehenden Ansprüche, bei welcher das Bedienelement (22) im Wesentlichen kreisringförmig ausgebildet ist,
ein zentraler Abschnitt (32) des Halteelements (16) zumindest teilweise lichtdurchlässig ausgestaltet ist, und
die Bedienvorrichtung ferner eine Anzeigevorrichtung (34) aufweist, die im Bereich des zentralen Abschnitts (32) des Halteelements (16) auf der Leiterplatte (26) angeordnet ist.

6. Bedienvorrichtung nach einem der vorhergehenden Ansprüche, bei welcher das Bedienelement (22) im Wesentlichen kreisringförmig ausgebildet ist, und die Bedienvorrichtung ferner im Bereich eines zentralen Abschnitts (32) des Halteelements (16) wenigstens eine Berührungstaste (36) aufweist.

## Claims

1. Operator control apparatus, in particular for an electronic household appliance, comprising:
an operator control panel (12) with a cutout (14) in the form of an aperture;
a printed circuit board (26) which is arranged on an inner side of the operator control panel (12) facing away from a user;
an operator control element (22) which is at least partially arranged within the cutout (14) of the operator control panel (12) and is rotatable about an axis of rotation running perpendicular to the plane of the operator control panel (12);
a rotation detection device for detecting a rotational movement and/or a rotational position of the operator control element (22), said rotation detection device comprising an encoder (30) provided on the operator control element (22) and an optical sensor (28) arranged on the printed circuit board (26); and
a holding element (16) with a receiving portion (20) for at least partially receiving the operator control element (22), wherein the operator control element (22) is rotatably mounted in the receiving portion (20), and wherein the holding element (16) is designed, in a portion (21a, 21b) provided between the encoder (30) of the operator control element (22) and the optical sensor (28) of the printed circuit board (26), to be at least partially permeable to the radiation used by the optical sensor (28),
**characterized in that**
the holding element (16) is a closed fluid-tight holding element which is inserted into the cutout (14) of the operator control panel (12) and is fluid-tightly sealed in relation to the operator control panel (12) by means of a seal device (18) comprising a labyrinth seal, with the result that the printed circuit board (26) is protected behind a closed fluid-tight surface composed of operator control panel (12) and holding element (16); and
the holding element (16) comprises, in the region of the receiving portion, a clamping apparatus (24) for latching the operator control element (22) in a direction parallel to the axis of rotation of the operator control element (22) in the receiving portion (20).

2. Operator control apparatus according to Claim 1, wherein the encoder (30) of the operator control element (22) has a reflection surface coded in the peripheral direction of the operator control element.

3. Operator control apparatus according to either of the preceding claims, wherein the receiving portion (20) of the holding element (16) comprises a recess, the encoder (30) of the operator control element (22) is positioned within the recess, and a bottom portion (21a) of the recess facing towards the printed circuit board (26) and/or a side wall (21b) of the recess are/is designed to be at least partially permeable to radiation.

4. Operator control apparatus according to one of the preceding claims, wherein the operator control element (22) is substantially circular or circular-ring-shaped.

5. Operator control apparatus according to one of the preceding claims, wherein the operator control element (22) is substantially circular-ring-shaped,
a central portion (32) of the holding element (16) is designed to be at least partially permeable to light, and
the operator control apparatus further comprises a display apparatus (34) which is arranged in the region of the central portion (32) of the holding element (16) on the printed circuit board (26).

6. Operator control apparatus according to one of the preceding claims, wherein the operator control element (22) is substantially circular-ring-shaped, and the operator control apparatus further comprises, in the region of a central portion (32) of the holding element (16), at least one touch key (36) .

## Revendications

1. Dispositif de commande, notamment d'appareil ménager électronique, ledit dispositif de commande comprenant :
un panneau de commande (12) pourvu d'un évidement (14) se présentant sous la forme d'un passage ;
une carte de circuit imprimé (26) qui est disposée sur un côté intérieur du panneau de commande (12) qui est opposé à un utilisateur ;
un élément de commande (22) qui est disposé au moins partiellement à l'intérieur de l'évidement (14) du panneau de commande (12) et qui peut tourner sur un axe de rotation qui s'étend perpendiculairement au plan du panneau de commande (12) ;
un module de détection de rotation qui est destiné à détecter un mouvement de rotation et/ou une position en rotation de l'élément de commande (22) et qui comporte un codeur (30) prévu sur l'élément de commande (22) et un capteur optique (28) disposé sur la carte de circuit imprimé (26) ; et
un élément de retenue (16) comprenant une portion de réception (20) destinée à recevoir au moins partiellement l'élément de commande (22), l'élément de commande (22) étant monté de manière rotative dans la portion de réception (20), et l'élément de retenue (16) étant conçu, dans une portion (21a, 21b) prévue entre le codeur (30) de l'élément de commande (22) et le capteur optique (28) de la carte de circuit imprimé (26), pour être au moins partiellement transparent au rayonnement utilisé par le capteur optique (28),
**caractérisé en ce que**
l'élément de retenue (16) est un élément de retenue fermé étanche aux fluides qui est inséré dans l'évidement (14) du panneau de commande (12) et qui est rendu étanche aux fluides par rapport au panneau de commande (12) au moyen d'un module d'étanchéité (18) qui comporte une garniture d'étanchéité en labyrinthe de façon à protéger la carte de circuit imprimé (26) derrière une surface fermée étanche aux fluides formée à partir du panneau de commande (12) et de l'élément de retenue (16) ; et
l'élément de retenue (16) comporte dans la zone de la portion de réception un dispositif de serrage (24) destiné à encliqueter l'élément de commande (22) dans une direction parallèle à l'axe de rotation de l'élément de commande (22) dans la portion de réception (20) .

2. Dispositif de commande selon la revendication 1, dans lequel le codeur (30) de l'élément de commande (22) comporte une surface de réflexion codée suivant la direction circonférentielle de l'élément de commande.

3. Dispositif de commande selon l'une des revendications précédentes, dans lequel la portion de réception (20) de l'élément de retenue (16) comporte un évidement, le codeur (30) de l'élément de commande (22) est positionné à l'intérieur de l'évidement, et une portion de fond (21a) de l'évidement, laquelle est dirigée vers la carte de circuit imprimé (26), et/ou une paroi latérale (21b) de l'évidement sont conçues pour être au moins partiellement transparentes au rayonnement.

4. Dispositif de commande selon l'une des revendications précédentes, dans lequel l'élément de commande (22) est sensiblement de forme circulaire ou d'anneau de cercle.

5. Dispositif de commande selon l'une des revendications précédentes, dans lequel l'élément de commande (22) est sensiblement de forme d'anneau ou de cercle,
une portion centrale (32) de l'élément de retenue (16) est conçue pour être au moins partiellement transparente, et
le dispositif de commande comporte en outre un dispositif d'affichage (34) qui est disposé dans la zone de la portion centrale (32) de l'élément de retenue (16) sur la carte de circuit imprimé (26).

6. Dispositif de commande selon l'une des revendications précédentes, dans lequel l'élément de commande (22) est sensiblement en forme d'anneau de cerce, et le dispositif de commande comporte en outre au moins une touche tactile (36) dans la zone d'une portion centrale (32) de l'élément de retenue (16).
